# EUROPEAN PATENT APPLICATION

(11) **EP 3 511 747 A1**
(43) Date of publication of application: **17.07.2019**
(21) Application number: 17810248.9
(22) Date of filing: 05.06.2017
(51) Int. Cl.: G02B 5/02, B32B 7/02, F21V 5/00, G02F 1/1335, G02F 1/13357, G09F 9/30, H01L 27/32, H01L 51/50

(54) **LIGHT-DIFFUSING FILM AND PRODUCTION METHOD THEREFOR, AND DISPLAY DEVICE**

(30) Priority: 06.06.2016 JP 2016112812
(71) Applicant: Daicel Corporation, Osaka-shi, Osaka 530-0011 (JP)
(72) Inventor: SUGAWARA, Yoshitaka, Amagasaki-shi Hyogo 661-0964 (JP)
(74) Representative: Grünecker Patent- und Rechtsanwälte PartG mbB
(86) International application number: PCT/JP2017/020771
(87) International publication number: WO 2017/213071

(57) **Abstract**

A light-diffusing film having a haze of 50% or greater, an internal haze of 15% or less, and a total light transmittance of 90% or greater is prepared.

The chromaticity b* of the transmitted light through this light-diffusing film may be 10 or less, and the chromaticity a* may be 2 or less.

This light-diffusing film may contain a transparent film, and a light-diffusing layer formed on at least one face of this transparent film, and the 60° gloss of the light-diffusing layer may be 10% or less.

The arithmetic average surface roughness Ra of a surface of the light-diffusing layer may be 0.3 µm or greater.

The average interval Sm of recesses and protrusions of the surface of the light-diffusing layer may be 100 µm or less.

The light-diffusing layer may be a cured product of a curable composition containing at least one type of polymer component and at least one type of curable resin precursor component. This light-diffusing film exhibits high degree of light diffusion and high lightness.

## Description

### Technical Field

The present invention relates to a light-diffusing film that can diffuse light isotropically and that can be used in various display devices such as organic electroluminescence (EL) displays and liquid crystal display (LCD) devices, a production method therefor, and a display device having the film.

### Background Art

Light-diffusing films are widely used in lighting covers, image display devices (such as organic EL displays and liquid crystal display devices), and the like.

Optical characteristics required for such light-diffusing films include characteristics such as high transparency (total light transmittance) and enhancement of visibility by providing a viewer with neutral white light, which is not a color biased toward yellow or red, in addition to light-diffusing characteristics to enhance antiglare properties and the like achieved by a high haze.

Furthermore, in the image display devices, high visibility in relation to image quality is required.

For example, in organic EL displays, color unevenness tends to occur due to unevenness of luminance among pixels, and improvement of color unevenness (enhancement of visibility) by light diffusion by a light-diffusing film and the like is also required.

A light-diffusing film is produced typically by dispersing fillers in a resin.

JP 2008-040479 A (Patent Document 1) discloses a light-diffusing sheet including a light-diffusing layer formed from a transparent resin matrix material containing first light diffusion particles having an average particle size of 1 to 50 µm and second light diffusion particles having a refractive index that is greater than a refractive index of the first light diffusion particles and having an average particle size of 0.01 to 1 µm in a transparent resin.

This document describes acrylic acid resins, acrylic amino resins, and epoxy resins as the transparent resin; polystyrene, polycarbonate, styrene-acrylonitrile copolymers, polypropylene, silicon dioxide, polymethyl methacrylate, and quartz as materials for the first light diffusion particles; and titanium dioxide, antimony oxide, barium sulfate, zinc sulfate, and calcium carbonate as materials for the second light diffusion particles.

Furthermore, JP 3753785 B (Patent Document 2) also discloses a light-diffusing film formed by coating a resin composition, in which 5 to 150 parts by weight of polystyrene particles having an average particle size of 1 to 70 µm is dispersed per 100 parts by weight of polyester, onto one face of a transparent base film.

Furthermore, JP 2009-109702 A (Patent Document 3) discloses a light-diffusing sheet containing particles having a weight average molecular weight of 7 µm or less in a base resin, the light-diffusing sheet having a haze of 45% or greater.

In Examples of this document, methyl methacrylate-styrene-divinylbenzene copolymer particles having the weight average particle size of 5 µm are dispersed in a methyl methacrylate-butadiene-styrene resin to form a surface layer having the average roughness Ra of 0.39 µm, the average interval between protrusions and recesses (Sm) of 42 µm, the total light transmittance of 89%, and the haze of 59%.

Although a light-diffusing film in which a filler is dispersed increases a degree of light diffusion with the increase of a haze value as a result of the increase of the refractive index difference between a matrix material constituting the light-diffusing layer and the filler to be dispersed,
light at a shorter wavelength side is scattered in a wider angle as an internal haze increases, and thus visibility is reduced and the light-diffusing film appears yellowish and dull when a display device is visually observed from a front face.

Furthermore, transparency is also reduced because back scattering tends to occur. Furthermore, degree of light diffusion is low, and visibility cannot be sufficiently enhanced in the organic EL displays, in which color unevenness occurs.

As described above, the known techniques to increase haze by dispersing particles having different refractive indexes in a transparent resin suffers from a trade-off relationship between the light-diffusing characteristics and visibility and it was difficult to achieve both good light-diffusing characteristics and visibility simultaneously.

### Citation List

### Patent Literature

Patent Document 1: JP 2008-040479 A (Claims)
Patent Document 2: JP 3753785 B (Claim 1)
Patent Document 3: JP 2009-109702 A (Claims and Examples)

### Summary of Invention

### Technical Problem

Therefore, an objective of the present invention is to provide a light-diffusing film having a high degree of light diffusion and high lightness, a production method therefor, and a display device having the film.

Another objective of the present invention is to provide a light-diffusing film having high transparency and low yellowness, a production method therefor, and a display device having the film.

Yet another objective of the present invention is to provide a light-diffusing film that can isotropically scatter transmitted light and that can enhance visibility of various display devices, a production method therefor, and a display device having the film.

### Solution to Problem

As a result of diligent research to solve the problems described above, the inventor of the present invention succeeded in preparing a light-diffusing film having a haze of 50% or greater, an internal haze of 15% or less, and a total light transmittance of 90% or greater by forming and curing a phase-separated structure by wet spinodal decomposition of a specific curable composition.

The inventor of the present invention discovered that, in such a light-diffusing film, both a high degree of light diffusion and high lightness, which are in trade-off relationship in the known technologies, can be achieved simultaneously, and thus completed the present invention.

That is, the light-diffusing film according to the present invention has a haze of 50% or greater, an internal haze of 15% or less, and a total light transmittance of 90% or greater. With the light-diffusing film according to the present invention, a chromaticity b* of transmitted light may be 10 or less. Furthermore, with the light-diffusing film according to the present invention, a chromaticity a* of transmitted light may be 2 or less.

The light-diffusing film according to the present invention may contain a transparent base layer, and a light-diffusing layer formed on at least one face of this transparent base layer, and the 60° gloss of the light-diffusing layer may be 10% or less.

The arithmetic average surface roughness Ra of a surface of the light-diffusing layer may be 0.3 µm or greater.

The average interval Sm of recesses and protrusions (average interval of recess/protrusion) of the surface of the light-diffusing layer may be 100 µm or less.

The light-diffusing layer may be a cured product of a curable composition containing at least one type of polymer component and at least one type of curable resin precursor component. At least two components selected from the group consisting of the polymer component and the curable resin precursor component can be phase-separated by wet spinodal decomposition (spinodal decomposition from a liquid phase). The polymer component may contain at least one type selected from the group consisting of (meth)acrylic polymers that may have a polymerizable group, urethane-modified polyesters, and cellulose esters.

The curable resin precursor component may contain at least one type selected from the group consisting of polyfunctional (meth)acrylate, epoxy (meth)acrylate, polyester (meth)acrylate, urethane (meth)acrylate, and silicone (meth)acrylate.

The curable resin precursor component may contain silica nanoparticles.

The present invention also includes a method for producing the light-diffusing film described above, the method including:
phase-separating at least two components selected from the group consisting of a polymer component and a curable resin precursor component with wet spinodal decomposition by coating and drying a curable composition containing at least one type of polymer component and at least one type of curable resin precursor component on a support body; and
curing a phase-separated curable composition by heat or active energy rays.

The present invention also includes a display device including the said light-diffusing film. The display device of according to the present invention may be an organic EL display. Furthermore, the display device according to the present invention may be a liquid crystal display device having a collimated backlight unit but no prism sheet, and the light-diffusing film may be arranged on a front face of a visible side of a liquid crystal element.

Note that, in the present specification and claims, (meth)acrylate includes both methacrylate and acrylate.

### Advantageous Effects of Invention

According to the present invention, the light-diffusing film with both high degree of light diffusion and high lightness can be achieved, the resulting film having a haze of 50% or greater, an internal haze of 15% or less, and a total light transmittance of 90% or greater. Furthermore, this light-diffusing film has high transparency and low yellowness. Furthermore, this light-diffusing film can isotropically scatter transmitted light. Therefore, this light-diffusing film can enhance visibility of various display devices. Description of Embodiments

### Optical characteristics of light-diffusing film

The light-diffusing film according to the present invention has excellent light-diffusing characteristics and a high haze.

Specifically, the haze of the light-diffusing film according to the present invention is 50% or greater (e.g. from 50 to 100%), for example approximately from 60 to 99%, preferably from 65 to 98%, and more preferably from 70 to 95% (especially, from 75 to 93%).

For the applications in which the high degree of light diffusion is required, the haze may be 80% or greater (e.g. approximately from 85 to 95%).

In a case where the haze is less than 50%, the degree of light diffusion is reduced, and antiglare properties and visibility of an organic EL display or the like are reduced.

Although the light-diffusing film according to the present invention has such a high haze, the internal haze thereof is low.

Specifically, the internal haze of the light-diffusing film according to the present invention is 15% or less (e.g. from 0 to 15%), for example approximately from 0.1 to 13%, preferably from 0.3 to 10%, and more preferably from 0.5 to 8% (especially, from 1 to 7%).

For the purposes where low yellowness is required, the internal haze may be 6% or less (e.g. approximately from 1 to 5%).

When the internal haze is greater than 15%, the yellowness becomes high.

Because the light-diffusing film according to the present invention has a low internal haze while having a high haze, the light-diffusing film has high transparency.

The light-diffusing film according to the present invention has high transparency in spite of a high haze because of a low internal haze.

Specifically, the total light transmittance of the light-diffusing film of according to the present invention is 90% or greater (e.g. from 90 to 100%), for example approximately from 91 to 99.9%, preferably from 92 to 99.8%, and more preferably from 93 to 99.5% (especially, from 94 to 99.3%).

In the present specification and claims, the haze, the internal haze, and the total light transmittance can be measured by using a haze meter (NDH-300A, available from Nippon Denshoku Industries Co., Ltd.) in accordance with JIS K 7105.

Note that the internal haze can be measured by measuring a haze, by making the surface recess and protrusion shape flat by coating a resin layer, or by adhering a transparent smooth film onto the surface recess and protrusion shape through a transparent adhesive layer.

The light-diffusing film according to the present invention has such a haze and transparency described above and has high lightness and, especially, a low internal haze, and thus, the light-diffusing film may be a film having low yellowness.

Specifically, the chromaticity b* of the transmitted light (transmitted hue) through the light-diffusing film according to the present invention may be 10 or less (e.g. from 0 to 10), for example approximately from 0.1 to 8, preferably from 0.3 to 7 (e.g. from 0.4 to 5), and more preferably from 0.5 to 3 (especially, from 1 to 2).

In a case where the chromaticity b* of the transmitted light is too high, the light-diffusing film may look dark and dull.

The light-diffusing film according to the present invention may be a film having low redness. Specifically, the chromaticity a* of the transmitted light through the light-diffusing film according to the present invention may be 2 or less, for example approximately from -2 to 1.5, preferably from -1 to 1, and more preferably from -0.5 to 0.5 (especially, from -0.3 to 0.3). When the chromaticity a* of the transmitted light is too high, the light-diffusing film may look dull.

In the present specification and claims, the transmitted hues a* and b* are measured by using a spectrophotometer (U-3010, available from Hitachi High-Tech Science Corporation) in accordance with JIS Z 8781.

### Light-diffusing layer

The light-diffusing film according to the present invention contains a light-diffusing layer for exhibiting the optical characteristics described above and the materials and structure thereof are not limited; however, typically, the optical characteristics are exhibited by formation of a number of fine and steep recess and protrusion shape, which correspond to the phase-separated structure, and thus visibility of the display devices can be enhanced by light-diffusing function, and antiglare property can be enhanced by suppressing reflection of outside scenery due to surface reflection.

Specifically, the arithmetic average surface roughness Ra of the light-diffusing layer surface (at least one surface in a case where the light-diffusing film is formed from the light-diffusing layer alone) may be 0.3 µm or greater, for example approximately from 0.3 to 2 µm, preferably from 0.5 to 1.5 µm, and more preferably from 0.7 to 1.2 µm (especially, from 0.8 to 1 µm).

In a case where Ra is too small, the protrusion shapes become dull, and the light-diffusing characteristics may be deteriorated.

The average interval of recesses and protrusions (average interval of recess/protrusion) Sm of the light-diffusing layer surface (at least one surface in a case where the light-diffusing film is formed from the light-diffusing layer alone) may be 100 µm or less, for example approximately from 5 to 100 µm, preferably from 10 to 80 µm, and more preferably from 20 to 60 µm (especially, from 30 to 50 µm).

In a case where Sm is too large, the protrusion shapes become dull, and the light-diffusing characteristics may be deteriorated.

In the present specification and claims, the arithmetic average surface roughness Ra and the average interval Sm of the recesses and protrusions are measured by using a contact-type surface roughness tester (Surfcom 570A, available from Tokyo Seimitsu Co., Ltd.) in accordance with JIS B 0601.

The 60° gloss of the light-diffusing layer surface (at least one surface in a case where the light-diffusing film is formed from the light-diffusing layer alone) may be 10% or less, for example approximately from 0.1 to 10%, preferably from 0.2 to 8%, and more preferably from 0.3 to 5% (especially, from 0.5 to 3%).

In a case where the 60° gloss is too large, the light-diffusing characteristics may be deteriorated.

In the present specification and claims, the 60° gloss can be measured by using a glossmeter (IG-320, available from HORIBA, Ltd.) in accordance with JIS K 8741.

The light-diffusing film according to the present invention comprises a light-diffusing layer, and may be formed from the light-diffusing layer alone or may contain a transparent base layer and a light-diffusing layer formed on at least one face of this transparent base layer. The surface of the light-diffusing layer typically has the recess and protrusion shape described above, and this recess and protrusion shape is formed by spinodal decomposition (wet spinodal decomposition) from the liquid phase.

The light-diffusing layer having such a recess and protrusion shape may be a cured product of a curable composition comprising at least one type of polymer component and at least one type of curable resin precursor component.

In more detail, for the light-diffusing layer, a composition (mixture liquid) comprising at least one type of polymer component, at least one type of curable resin precursor component, and a solvent is used, and during a process of vaporizing or removing the solvent from the liquid phase of this composition by drying or the like, the phase separation by spinodal decomposition occurs as the concentration is increased.

And thus, a phase-separated structure having a relatively regular distance between the phases is formed.

More specifically, the wet spinodal decomposition can be performed typically by coating the composition (uniform solution) onto a support body and vaporizing the solvent from the coated layer.

In a case where a releasable support body is used as the support body, a light-diffusing film formed from the light-diffusing layer alone can be obtained by releasing the light-diffusing layer from the support body, and a light-diffusing film having a layered structure formed from a transparent base layer and a light-diffusing layer can be obtained by using a transparent non-releasable support body (transparent base layer) as the support body.

### Polymer component

As the polymer component, typically, a thermoplastic resin is used.

The thermoplastic resin is not particularly limited as long as the thermoplastic resin has high transparency and can form the surface recess and protrusion shape described above by spinodal decomposition, and
examples thereof include styrene-based resins, (meth)acrylic polymers, vinyl organic acid ester-based polymers, vinyl ether-based polymers, halogen-containing resins, polyolefins (including alicyclic polyolefins), polycarbonate, polyester, polyamide, thermoplastic polyurethane, polysulfone-based resins (polyether sulfone, polysulfone, and the like), polyphenylene ether-based resins (polymers of 2,6-xylenol, and the like), cellulose derivatives (cellulose esters, cellulose carbamates, cellulose ethers, and the like), silicone resins (polydimethylsiloxane, polymethylphenylsiloxane, and the like), rubbers or elastomers (diene rubbers such as polybutadienes and polyisoprenes, styrene-butadiene copolymers, acrylonitrile-butadiene copolymers, acrylic rubbers, urethane rubbers, silicone rubbers, and the like), and the like.

One type of these thermoplastic resins or a combination of two or more types of these thermoplastic resins can be used.

Among these polymer components, styrene-based resins, (meth)acrylic polymers, vinyl acetate-based polymers, vinyl ether-based polymers, halogen-containing resins, alicyclic polyolefins, polycarbonates, polyesters, polyamides, cellulose derivatives, silicone resins, rubbers or elastomers, and the like are generally used.

Furthermore, as the polymer component, a polymer component that is amorphous and that is soluble to an organic solvent (especially, a common solvent that can dissolve a plurality of the polymer components and the curable resin precursor components) is typically used. In particular, polymer components having high moldability or film-formability, high transparency, and high weatherability, such as styrene-based resins, (meth)acrylic polymers, alicyclic polyolefins, polyester-based resins, and cellulose derivatives (cellulose esters and the like), are preferable. (Meth)acrylic polymers, polyesters, and cellulose esters are particularly preferable.

As the (meth)acrylic polymer, homopolymers or copolymers of (meth)acrylic monomers, copolymers of (meth)acrylic monomers and copolymerizable monomers, and the like can be used.

Examples of the (meth)acrylic monomer include (meth)acrylic acid; C₁₋₁₀ alkyl (meth)acrylates, such as methyl(meth)acrylate, ethyl(meth)acrylate, butyl(meth)acrylate, t-butyl (meth)acrylate, isobutyl (meth)acrylate, hexyl (meth)acrylate, octyl (meth)acrylate, and 2-ethylhexyl (meth)acrylate;
aryl (meth)acrylates, such as phenyl (meth)acrylate;
hydroxyalkyl (meth)acrylates, such as hydroxyethyl (meth)acrylate and hydroxypropyl (meth)acrylate;
glycidyl (meth)acrylate;
N,N-dialkylaminoalkyl (meth)acrylate;
(meth)acrylonitrile; (meth)acrylates having an alicyclic hydrocarbon group, such as tricyclodecane; and the like.

Examples of the copolymerizable monomer include the styrene-based monomers, vinyl ester-based monomers, maleic anhydride, maleic acid, fumaric acid, and the like.

One type of these monomers or a combination of two or more types of these monomers can be used.

Examples of the (meth)acrylic polymer include poly(meth)acrylates, such as polymethyl methacrylate, methyl methacrylate-(meth)acrylic acid copolymers, methyl methacrylate-(meth)acrylate copolymers, methyl methacrylate-acrylate-(meth)acrylic acid copolymers, (meth)acrylate-styrene copolymers (MS resins and the like), and the like.

Among these, poly-C₁₋₆ alkyl (meth)acrylates such as polymethyl (meth)acrylate are preferable, and methyl methacrylate-based polymers having methyl methacrylate as a main component (approximately, from 50 to 100 wt.%, and preferably from 70 to 100 wt.%) are particularly preferable.

Examples of the polyester include aromatic polyesters which use aromatic dicarboxylic acid such as terephthalic acid (homopolyesters, including poly-C₂₋₄ alkylene terephthalates, such as polyethylene terephthalate and polybutylene terephthalate, and poly-C₂₋₄ alkylene naphthalates; and copolyesters having a C₂₋₄ alkylene arylate unit (C₂₋₄ alkylene terephthalate and/or C₂₋₄ alkylene naphthalate unit) as a main component (e.g. 50 wt.% or greater)) and the like.

The copolyester includes copolyesters in which, among structural units of poly-C₂₋₄ alkylene arylate, a part of C₂₋₄ alkylene glycol is substituted with polyoxy C₂₋₄ alkylene glycol, C₆₋₁₀ alkylene glycol, alicylic diol (cyclohexane dimethanol, hydrogenated bisphenol A, and the like), diol having an aromatic ring (9,9-bis(4-(2-hydroxyethoxy)phenyl)fluorene having a fluorene side chain, bisphenol A, bisphenol A-alkylene oxide adduct, and the like), or the like; and copolyester in which a part of aromatic dicarboxylic acid is substituted with phthalic acid, an asymmetric aromatic dicarboxylic acid such as isophthalic acid, an aliphatic C₆₋₁₂ dicarboxylic acid, such as adipic acid, or the like. The polyester-based resin includes polyarylate-based resins, aliphatic polyesters in which aliphatic dicarboxylic acid such as adipic acid is used, and homopolymers and copolymers of lactone such as ε-caprolactone. The polyester may be modified and may be a urethane-modified polyester which is modified with a polyester-type urethane or a polyether-type urethane.

Among these, amorphous copolyesters (e.g. C₂₋₄ alkylene arylate-based copolyesters and the like) are preferable, and from the perspective of promoting phase separation by spinodal decomposition, urethane-modified polyesters (especially, urethane-modified aromatic polyesters and urethane-modified copolymer polyesters) are particularly preferable.

Examples of the cellulose esters include aliphatic organic acid esters (cellulose acetates, such as cellulose diacetate and cellulose triacetate; C₁₋₆ organic acid esters, such as cellulose propionate, cellulose butyrate, cellulose acetate propionate, and cellulose acetate butyrate, and the like), aromatic organic acid esters (C₇₋₁₂ aromatic carboxylates, such as cellulose phthalate and cellulose benzoate), inorganic acid esters (e.g. cellulose phosphate, cellulose sulfate, and the like), and the like, and the cellulose ester may be a mixed acid ester, such as cellulose acetate/nitrate. One type of these cellulose esters or a combination of two or more types of these cellulose esters can be used. Among these, cellulose C₂₋₄ acylates, such as cellulose diacetate, cellulose triacetate, cellulose acetate propionate, and cellulose acetate butyrate, are preferable; and cellulose acetate C₃₋₄ acylates, such as cellulose acetate propionate, are particularly preferable.

The polymer component (especially, (meth)acrylic polymer) may be a polymer having a functional group that relates to the curing reaction (or a functional group that can react with the curable resin precursor component).

The polymer may contain the functional group in a main chain or in a side chain.

The functional group may be introduced into a main chain by copolymerization, co-condensation, or the like; however, the functional group is typically introduced into a side chain.

Examples of such a functional group include condensable groups and reactive groups (e.g. a hydroxy group, acid anhydride groups, a carboxyl group, an amino group or an imino group, an epoxy group, a glycidyl group, an isocyanate group, and the like), polymerizable groups (e.g. C₂₋₆ alkenyl groups, such as vinyl, propenyl, isopropenyl, butenyl, and allyl; C₂₋₆ alkynyl groups, such as ethynyl, propynyl, and butynyl; C₂₋₆ alkenylidene groups, such as vinylidene; and the like) or groups having these polymerizable groups ((meth)acryloyl groups and the like), and the like.

Among these functional groups, polymerizable groups are preferable.

Examples of the method of introducing the polymerizable group into a side chain include methods in which a thermoplastic resin having a functional group, such as a reactive group and/or a condensable group, and a polymerizable compound having a group that can react with the functional group are reacted, and the like.

In the thermoplastic resin having a functional group, examples of the functional group include a carboxyl group or an acid anhydride group thereof, a hydroxy group, an amino group, an epoxy groups, and the like.

In the case of a thermoplastic resin having a carboxyl group or an acid anhydride group thereof, examples of the polymerizable compound include polymerizable compounds having an epoxy group, a hydroxyl group, an amino group, an isocyanate group, or the like. Among these, a polymerizable compound having an epoxy group, including epoxycyclo-C₅₋₈ alkenyl (meth)acrylate, such as epoxycyclohexenyl (meth)acrylate, glycidyl (meth)acrylate, allyl glycidyl ether, and the like, is generally used.

Representative examples include a combination of a thermoplastic resin having a carboxyl group or an acid anhydride group thereof and an epoxy group-containing compound, especially a combination of a (meth)acrylic polymer ((meth)acrylic acid-(meth)acrylate copolymer or the like) and an epoxy group-containing (meth)acrylate (epoxycycloalkenyl (meth)acrylate, glycidyl (meth)acrylate, and the like).

Specifically, a polymer in which a polymerizable unsaturated group is introduced into a part of a carboxyl group in a (meth)acrylic polymer, such as a (meth)acrylic polymer in which an epoxy group of 3,4-epoxycyclohexenylmethyl acrylate is reacted with a part of a carboxyl group of a (meth)acrylic acid-(meth)acrylate copolymer to introduce a polymerizable group (photopolymerizable unsaturated group) in a side chain (CYCLOMER P, available from Daicel Corporation), can be used.

The introduced amount of the functional group related to the curing reaction of the thermoplastic resin (especially, polymerizable group) is approximately from 0.001 to 10 mol, preferably from 0.01 to 5 mol, and more preferably from 0.02 to 3 mol, per 1 kg of the thermoplastic resin.

An appropriate combination of these polymer components can be used.

That is, the polymer component may be composed of a plurality of polymers.

The plurality of polymers may be phase-separable by wet spinodal decomposition. Furthermore, the plurality of polymers may be immiscible to each other.

In a case where the plurality of polymers is combined, a combination of a first polymer and a second polymer is not particularly limited, and for example, a plurality of polymers that are immiscible each other roughly at a processing temperature, such as two immiscible polymers, can be appropriately combined and used.

For example, in a case where the first polymer is a (meth)acrylic polymer (e.g. polymethyl methacrylate, (meth)acrylic polymer having a polymerizable group, or the like), the second polymer may be a cellulose ester (cellulose acetate C₃₋₄ acylates, such as cellulose acetate propionate, or the like), or a polyester (urethane-modified polyester or the like).

Furthermore, from the perspective of scratch durability after being cured, at least one of the plurality of polymers [is], e.g. at least one polymer among the polymers that are immiscible each other (in a case where the first polymer and the second polymer are combined, at least one of the polymers) [is], preferably a polymer having a functional group that can react with the curable resin precursor component (especially polymerizable group) in a side chain.

The weight ratio of the first polymer to the second polymer can be selected from the range of, for example, the former/the latter = approximately 1/99 to 99/1, and preferably 5/95 to 95/5. In a case where the first polymer is a (meth)acrylic polymer and the second polymer is a cellulose ester or polyester, the weight ratio of these polymers is the former/the latter = approximately 50/50 to 99/1, preferably 60/40 to 95/5, and more preferably 65/35 to 90/10 (particularly, 70/30 to 80/20).

Note that, as the polymer to form the phase-separated structure, the thermoplastic resin and/or another polymer may be contained besides the two immiscible polymers.

The glass transition temperature of the polymer component can be selected from the range of, for example, approximately -100°C to 250°C, preferably -50°C to 230°C, and more preferably 0 to 200°C (e.g. approximately 50 to 180°C).

Note that, from the perspective of the surface hardness, the glass transition temperature of 50°C or higher (e.g. approximately from 70 to 200°C), and preferably 100°C or higher (e.g. approximately from 100 to 170°C), is advantageous.

The weight average molecular weight of the polymer can be selected from, for example, approximately 1000000 or less, and preferably from the range of 1000 to 500000.

### Curable resin precursor component

The curable resin precursor component is a compound having a functional group that reacts by heat, active energy rays (such as ultraviolet rays and electron beams) or the like, and various curable compounds that can form resins (especially, cured or crosslinked resins) by curing or crosslinking by heat, active energy rays, or the like can be used.

Examples of the curable resin precursor component include thermosetting compounds or resins (low molecular weight compounds having an epoxy group, polymerizable group, isocyanate group, alkoxysilyl group, silanol group, or the like (such as epoxy-based resins, unsaturated polyester-based resins, urethane-based resins, and silicone-based resins) and the like), active beam (ultraviolet rays or the like) curable photocurable compounds (ultraviolet curable compounds, such as photocurable monomers and oligomers, and the like), and the like.

The photocurable compound may be an electron beam (EB) curable composition or the like. Note that the photocurable compound, such as a photocurable monomer or oligomer, or a photocurable resin that may have a low molecular weight, may also simply referred to as "photocurable resin".

The photocurable compound includes, for example, a monomer and an oligomer (or a resin, especially a low molecular weight resin).

Examples of the monomer include monofunctional monomers ((meth)acrylic monomers such as (meth)acrylate, vinyl-based monomers such as vinyl pyrrolidone, (meth)acrylates having a crosslinked cyclic hydrocarbon group such as isobornyl (meth)acrylate, and adamantyl (meth)acrylate, and the like), polyfunctional monomers having at least two polymerizable unsaturated bonds (alkylene glycol di(meth)acrylate, such as ethylene glycol di(meth)acrylate, propylene glycol di(meth)acrylate, butanediol di(meth)acrylate, neopentyl glycol di(meth)acrylate, and hexanediol di(meth)acrylate; (poly)oxyalkylene glycol di(meth)acrylate, such as diethylene glycol di(meth)acrylate, dipropylene glycol di(meth)acrylate, and polyoxytetramethylene glycol di(meth)acrylate; di(meth)acrylate having a crosslinked cyclic hydrocarbon group, such as tricyclodecanedimethanol di(meth)acrylate and adamantane di(meth)acrylate; polyfunctional monomers having approximately 3 to 6 polymerizable unsaturated bonds such as glycerin tri(meth)acrylate, trimethylolpropane tri(meth)acrylate, trimethylolethane tri(meth)acrylate, pentaerythritol tri(meth)acrylate, ditrimethylolpropane tetra(meth)acrylate, pentaerythritol tetra(meth)acrylate, dipentaerythritol penta(meth)acrylate, and dipentaerythritol hexa(meth)acrylate), and the like.

Examples of the oligomer or resin include (meth)acrylate of bisphenol A-alkylene oxide adduct, epoxy (meth)acrylate (bisphenol A-type epoxy (meth)acrylate, novolac-type epoxy (meth)acrylate, and the like), polyester (meth)acrylate (e.g. aliphatic polyester-type (meth)acrylate, aromatic polyester-type (meth)acrylate, and the like), (poly)urethane (meth)acrylate (polyester-type urethane (meth)acrylate, polyether-type urethane (meth)acrylate, and the like), silicone (meth)acrylate, and the like.

One type of these photocurable compounds or a combination of two or more types of these photocurable compounds can be used.

Among these, the photocurable compound is a photocurable compound that can be cured in a short period of time, such as an ultraviolet curable compound (monomer, oligomer, resin that may have a low molecular weight, or the like) or an EB curable compound.

In particular, a practically advantageous resin precursor is an ultraviolet curable resin. Furthermore, to enhance the durability, such as scratch durability, the photocurable resin is preferably a compound having at least two (approximately, preferably from 2 to 6, and more preferably from 2 to 4) polymerizable unsaturated bonds per molecule.

The weight average molecular weight of the curable resin precursor component is not particularly limited, but is approximately 5000 or less, preferably 2000 or less, and more preferably 1000 or less, by gel permeation chromatography (GPC), based on calibration with polystyrene, taking miscibility with the polymer into consideration.

Depending on the type of the curable resin precursor component, the curable resin precursor component may contain a filler in a range that the internal haze value becomes 15% or less to suppress the yellowness of the light-diffusing film.

As the filler, for example, inorganic microparticles, such as silica particles, titania particles, zirconia particles, and alumina particles, or organic microparticles, such as crosslinked (meth)acrylic polymer microparticles and crosslinked styrene-based resin particles.

One type of these fillers or a combination of two or more types of these fillers can be used.

Among these fillers, from the perspectives of excellent optical characteristics and ease of forming a steep protrusion and recess shape by spinodal decomposition, nanometer-sized silica particles (silica nanoparticles) are preferable.

The silica nanoparticles are preferably solid silica nanoparticles from the perspective of suppressing the yellowness of the light-diffusing film.

Furthermore, the average particle size of the silica nanoparticles is, for example, approximately from 1 to 800 nm, preferably from 3 to 500 nm, and more preferably from 5 to 300 nm.

The proportion of the filler (especially, the silica nanoparticles) may be approximately from 10 to 90 wt.%, for example approximately from 20 to 80 wt.%, preferably from 30 to 70 wt.%, and more preferably from 40 to 60 wt.%, relative to the total amount of the curable resin precursor component.

The curable resin precursor component may further contain a curing agent depending on the type of the curable resin precursor component.

For example, the thermosetting resin may contain a curing agent such as amines or polyvalent carboxylic acids, and the photocurable resin may contain photopolymerization initiator. Examples of the photopolymerization initiator includes ordinary components, such as acetophenones or propiophenones, benzyls, benzoins, benzophenones, thioxanthones, acylphosphine oxides, and the like.

The proportion of the curing agent, such as photocuring agent, is approximately from 0.1 to 20 wt.%, preferably from 0.5 to 10 wt.%, and more preferably from 1 to 8 wt.%, relative to the total amount of the curable resin precursor component.

The curable resin precursor component may further contain a curing accelerator.

For example, the photocurable resin may contain a photocuring accelerator, such as tertiary amines (dialkylamino benzoate and the like) or phosphine-based photopolymerization accelerators.

Among these curable resin precursor components, polyfunctional (meth)acrylates (such as (meth)acrylate having from approximately 2 to 8 polymerizable groups), epoxy (meth)acrylate, polyester (meth)acrylate, urethane (meth)acrylate, silicone (meth)acrylate, and the like are preferable.

Furthermore, the curable resin precursor component is preferably a curable resin precursor component containing silica nanoparticles, and is particularly preferably a silica nanoparticle-containing photocurable compound (especially, a polyfunctional (meth)acrylate, urethane (meth)acrylate, or silicone (meth)acrylate that contains silica nanoparticles).

In the present invention, from the perspective of ease of forming a steep recess and protrusion shape, the silica nanoparticle-containing curable resin precursor component is preferably included in the curable resin precursor component under a condition that the proportion of the silica nanoparticles relative to the total amount of the curable resin precursor component becomes the proportion described above.

### Combination of polymer component and curable resin precursor component

According to the present invention, among the polymer component and the curable resin precursor component, at least two components are used in a combination such that the components are phase-separated each other roughly at a processing temperature.

Examples of the combinations in which the phase separation takes place include (a) combination in which a plurality of polymer components is immiscible each other and is phase-separated, (b) combination in which a polymer component and a curable resin precursor component are immiscible each other and are phase-separated, (c) combination in which a plurality of curable resin precursor components is immiscible each other and is phase-separated, and the like.

Among these combinations, typically, (a) a combination of a plurality of polymer components and (b) a combination of a polymer component and a curable resin precursor component are preferable, and (a) a combination of a plurality of polymer components is particularly preferable.

In a case where the miscibility of the components to be phase-separated is high, the components are not effectively phase-separated in the drying process to vaporize the solvent, and thus function as the light-diffusing layer is deteriorated.

Note that the polymer component and the curable resin precursor component are typically immiscible each other.

In a case where the polymer component and the curable resin precursor component are immiscible and are phase-separated, a plurality of polymer components may be used as the polymer component.

In a case where the plurality of polymer components is used, at least one polymer component is immiscible relative to the curable resin precursor component, and the other polymer component may be miscible with the curable resin precursor component. Furthermore, the combination may be a combination of two polymer components that are immiscible each other and a curable resin precursor component (especially, a monomer or oligomer having a plurality of curable functional groups).

In a case where the polymer component is composed of a plurality of polymer components that are immiscible each other and is phase-separated, the curable resin precursor component is used in a combination in which the curable resin precursor component is, roughly at a processing temperature, miscible with at least one of the polymer component among the plurality of polymers that are immiscible.

That is, for example, in a case where the plurality of polymer components that are immiscible each other is constituted by a first polymer and a second polymer, the curable resin precursor component is miscible with at least one of the first polymer or the second polymer and may be miscible with both polymers; however, the curable resin precursor component is preferably only miscible with one polymer component.

In a case where the curable resin precursor component is miscible with both polymer components, the phase separation into at least two phases, which are a mixture containing the first polymer and the curable resin precursor component as main components and a mixture containing the second polymer and the curable resin precursor component as main components, occurs.

In a case where the miscibility of the selected plurality of polymer components is high, the polymer components are not effectively phase-separated in the drying process, in which the solvent is vaporized, and thus function as the light-diffusing layer is deteriorated.

The phase separation capability of the plurality of polymer components can be simply determined by preparing a uniform solution of the polymer components by using a good solvent for the components, and by visually observing whether a solid residue content becomes cloudy during the process of gradual vaporization of the solvent.

Furthermore, typically, a polymer component and a cured or crosslinked resin produced by curing the curable resin precursor component each have a refractive index that is different from the other.

Furthermore, refractive indexes of the plurality of polymer components (the first polymer and the second polymer) are different from each other.

The difference between the refractive index of the polymer component and the refractive index of the cured or crosslinked resin and the difference between the refractive indexes of the plurality of polymer components (the first polymer and the second polymer) may be, for example approximately from 0.001 to 0.2, and preferably from 0.05 to 0.15.

Specific examples of the combination include, in a case where the polymer component is a combination of a (meth)acrylic polymer having a polymerizable group and cellulose esters, the curable resin precursor component may be a combination of a silica nanoparticle-containing photocurable compound and silicone (meth)acrylate or may be urethane (meth)acrylate alone.

Furthermore, in a case where the polymer component is a combination of a (meth)acrylic polymer and urethane-modified polyester, the curable resin precursor component may be a combination of a silica nanoparticle-containing photocurable compound and silicone (meth)acrylate.

The ratio of the polymer component to the curable resin precursor component (weight ratio) is not particularly limited and can be selected from the range of, for example, the former/the latter = approximately 5/95 to 95/5, and from the perspective of surface hardness, approximately preferably 5/95 to 60/40, and more preferably 10/90 to 50/50 (particularly, 10/90 to 30/70).

### Transparent base layer

The transparent base layer may be formed from a transparent material; however, the material can be selected based on the purpose of the use and may be an inorganic material, such as glass.

From the perspectives of strength, moldability, and the like, an organic material is generally used.

Examples of the organic material include cellulose derivatives, polyesters, polyamides, polyimides, polycarbonates, (meth)acrylic polymers, and the like.

Among these, cellulose esters, polyesters, and the like are generally used.

Examples of the cellulose ester include cellulose acetates such as cellulose triacetate (TAC), cellulose acetate C₃₋₄ acylates such as cellulose acetate propionate and cellulose acetate butyrate, and the like. Examples of the polyester include polyalkylene arylates such as polyethylene terephthalate (PET) and polyethylene naphthalate (PEN), and the like.

Among these, from the perspective of excellent balance between mechanical properties and transparency or the like, a poly-C₂₋₄ alkylene C₈₋₁₂ arylate, such as PET or PEN, is preferable.

The transparent base layer may be a uniaxially or biaxially stretched film; however, from the perspectives of achieving low birefringence and achieving excellent optical isotropy, the transparent base layer may be an unstretched film.

The transparent base layer may be surface treated (e.g. corona discharge treatment, flame treatment, plasma treatment, ozone or ultraviolet irradiation treatment, and the like) and may have an easy adhesive layer.

### Characteristics of light-diffusing film

In addition to having high light scattering characteristics, the light-diffusing layer can increase scattering intensity in a specific angle range while isotropically transmitting and scattering the transmitted light.

Therefore, the light-diffusing layer can enhance visibility of display devices, such as organic EL displays, and can also enhance antiglare properties.

Thus, the light-diffusing film having a light-diffusing layer (a light-diffusing film formed only by the light-diffusing layer, a laminate film of the light-diffusing layer and the transparent base layer) may be used as is as an optical component (optical component of an organic EL display or a liquid crystal display device), or may form an optical component by being combined with an optical element (e.g. various optical elements arranged in an optical path, such as polarizing plate, waveplate, and light guide plate).

That is, at least one of optical path face of an optical element, the light-diffusing film according to the present invention may be arranged or laminated.

For example, the light-diffusing film may be laminated on at least one face of a waveplate, or the light-diffusing film may be arranged or laminated on an output face of a light guide plate.

Furthermore, the light-diffusing film in which the light-diffusing layer is imparted with scratch durability can be used as a protective film.

Thus, the light-diffusing film according to the present invention may be used as a laminate in which the light-diffusing film replaces at least one protective film among two protective films of a polarizing plate and is used, i.e. a laminate in which the light-diffusing film is laminated on at least one face of a polarizing plate.

The light-diffusing layer and the transparent base layer may contain various additives, such as leveling agents, stabilizers (antioxidants, UV absorbents, and the like), surfactants, watersoluble polymers, fillers, cross-linking agents, coupling agents, coloring agents, flame retardants, lubricants, waxes, preservatives, viscosity modifiers, thickeners, and antifoaming agents.

The proportion of each additive is, for example, approximately from 0.01 to 10 wt.% (especially, from 0.1 to 5 wt.%) relative to the total amount of each layer.

The thickness (average thickness) of the light-diffusing layer may be, for example, approximately from 0.3 to 20 µm, preferably approximately from 1 to 15 µm (e.g. from 1 to 10 µm), and typically approximately from 3 to 13 µm (particularly, from 7 to 11 µm). Note that, in a case where the light-diffusing film is constituted by the light-diffusing layer alone, the thickness (average thickness) of the light-diffusing layer is, for example, approximately from 1 to 100 µm, and preferably from 3 to 50 µm.

The thickness (average thickness) of the transparent base layer is, for example, approximately from 5 to 2000 µm, preferably from 15 to 1000 µm, and more preferably from 20 to 500 µm.

### Production method of light-diffusing film

The light-diffusing film according to the present invention may be obtained through performing the phase separation including coating and drying a curable composition containing at least one type of polymer component and at least one type of curable resin precursor component on a support body (especially, a transparent base layer) and phase-separating at least two components selected from the group consisting of the polymer component and the curable resin precursor component by wet spinodal decomposition; and a curing step of curing a phase-separated curable composition by heat or active energy rays.

In the phase separation step, the curable composition may contain a solvent.

The solvent can be selected depending on the types of the polymer component and the curable resin precursor component and the solubility, and the solvent needs to uniformly dissolve at least solid content (e.g. a plurality of polymer components and curable resin precursor components, a reaction initiator, and other additives).

In particular, the phase-separated structure may be controlled by adjusting the solubility of the solvent relative to the polymer component and the curable resin precursor.

Examples of such a solvent include ketones (acetone, methyl ethyl ketone, methyl isobutyl ketone, cyclohexanone, and the like), ethers (dioxane, tetrahydrofuran, and the like), aliphatic hydrocarbons (hexane and the like), alicyclic hydrocarbons (cyclohexane and the like), aromatic hydrocarbons (toluene, xylene, and the like), halocarbons (dichloromethane, dichloroethane, and the like), esters (methyl acetate, ethyl acetate, butyl acetate, and the like), water, alcohols (ethanol, isopropanol, butanol, cyclohexanol, and the like), cellosolves (methyl cellosolve, ethyl cellosolve, propylene glycol monomethyl ether (1-methoxy-2-propanol), and the like), cellosolve acetates, sulfoxides (dimethyl sulfoxide and the like), amides (dimethylformamide, dimethylacetamide, and the like) and the like. Furthermore, the solvent may be a mixed solvent.

Among these solvents, ketones such as methyl ethyl ketone are preferably included, and a mixed solvent of ketones and alcohols (butanol and the like) and/or cellosolves (1-methoxy-2-propanol and the like) is particularly preferable.

In the mixed solvent, the proportion of the alcohols and/or cellosolves (in a case where these are mixed, total amount) is approximately from 10 to 150 parts by weight, preferably from 20 to 100 parts by weight, and more preferably from 30 to 80 parts by weight, per 100 parts by weight of the ketones.

In a case where the alcohols and cellosolves are combined, the proportion of the cellosolves is, for example, from 1 to 100 parts by weight, preferably from 10 to 80 parts by weight, and more preferably from 30 to 70 parts by weight, per 100 parts by weight of the alcohols.

In an embodiment of the present invention, the appropriate combination of solvents enables adjustment of phase separation by spinodal decomposition and formation of a steep recess and protrusion shape.

The concentration of the solute (a polymer component, a curable resin precursor component, a reaction initiator, and other additives) in the mixture liquid can be selected in the range that causes phase separation and that does not impair casting properties and coating properties, and is, for example, approximately from 1 to 80 wt.%, preferably from 5 to 60 wt.%, and more preferably from 15 to 40 wt.% (especially, from 20 to 40 wt.%).

Examples of the coating method include known methods, such as a roll coater, an air knife coater, a blade coater, a rod coater, a reverse coater, a bar coater, a comma coater, a dip and squeeze coater, a die coater, a gravure coater, a microgravure coater, a silkscreen coater, a dipping method, a spraying method, a spinner method, and the like.

Among these methods, a bar coater method, a gravure coater method, and the like are generally used.

Note that, as necessary, a coating liquid may be coated for a plurality of times.

After the mixture liquid is casted or coated, phase separation by spinodal decomposition can be induced by vaporizing the solvent at a temperature that is lower than the boiling point of the solvent (e.g. a temperature that is approximately 1 to 120°C lower, preferably 5 to 50°C lower, and particularly 10 to 50°C lower, than the boiling point of the solvent).

The vaporization of the solvent can be performed typically by drying, e.g. by drying at a temperature approximately from 30 to 200°C (e.g. from 30 to 100°C), preferably from 40 to 120°C, and more preferably from 40 to 80°C, depending on the boiling point of the solvent.

By the spinodal decomposition involving such vaporization of the solvent, regularity or periodicity can be imparted to the average distance between domains of phase-separated structure.

In the curing step, the phase-separated structure formed by spinodal decomposition can be immediately fixed by curing the dried curable composition in the end by active rays (ultraviolet rays, electron beams, and the like), heat, or the like.

For the curing of the curable composition, heating, photoirradiation, and the like may be combined depending on the type of the curable resin precursor component.

The heating temperature can be selected from an appropriate range, e.g. approximately from 50 to 150°C.

The photoirradiation can be selected depending on the type of the photocurable component or the like, and typically, ultraviolet rays, electron beams, and the like can be used.

A general-purpose exposure light source is typically an ultraviolet ray irradiation apparatus.

As the light source, for example, for the ultraviolet ray, a Deep UV lamp, a low-pressure mercury lamp, a high-pressure mercury lamp, a superhigh-pressure mercury lamp, a halogen lamp, a laser light source (a light source, such as a helium-cadmium laser or an excimer laser), and the like can be used. The quantity of the irradiation light (irradiation energy) varies depending on the thickness of the coating. The quantity of the irradiation light may be, for example, approximately from 10 to 10000 mJ/cm², preferably from 20 to 5000 mJ/cm², and more preferably from 30 to 3000 mJ/cm². The photoirradiation may be performed in an inert gas atmosphere, as necessary.

### Display device

The light-diffusing film according to the present invention can enhance light scattering intensity in a specific angle range while isotropically transmitting and scattering the transmitted light.

Therefore, the light-diffusing film according to the present invention can be used as an optical component of various display devices, such as liquid crystal display (LCD) devices, organic EL displays, display devices with a touchscreen, and is especially useful as an optical element for LCD devices and organic EL displays.

In more detail, the LCD device may be a reflective liquid crystal display device in which a display unit including liquid crystal cells is illuminated by external light, or may be a transflective liquid crystal display device in which a backlight unit for illuminating a display unit is provided.

In the reflective LCD device, the display unit can be illuminated by taking in an incident light from the outside through the display unit, and reflecting the transmitted light transmitted through the display unit by a reflective member.

In the reflective LCD device, the light-diffusing film according to the present invention (especially, a laminate of a polarizing plate and the light-diffusing film according to the present invention) can be arranged in an optical path in front of the reflective member. For example, the light-diffusing film according to the present invention can be arranged or laminated on a front face of the display unit (front face of visible side) or the like and, particularly, may be arranged on a front face of a liquid crystal display device having a collimated backlight unit but having no prism sheet.

In the transflective LCD device, the backlight unit may have a light guide plate (e.g. a light guide plate having a wedge-shaped cross section) for allowing a light from a light source (a tubular light source such as a cold-cathode tube, a point light source such as a light emitting diode, or the like) incident from one side to emit from the front output surface. Furthermore, as necessary, a prism sheet may be arranged on the front face side of the light guide plate. Note that, typically, on a back face of a light guide plate, a reflecting member for reflecting light from a light source to output face side is arranged. In such a transflective LCD device, typically, the light-diffusing film according to the present invention can be arranged in an optical path in front of a light source. For example, the light-diffusing film according to the present invention can be arranged or laminated in between a light guide plate and a display unit, on a front face of a display unit, or the like.

In an organic EL display, an organic EL has a light emitting element for each pixel, and this light emitting element is typically formed by a negative electrode (such as a metal)/an electron-injecting layer/an electron-transporting layer/a light-emitting layer/a hole-transporting layer/a hole-injecting layer/a positive electrode (such as ITO)/a substrate (such as a glass plate or a transparent plastic plate). Also in an organic EL display, the light-diffusing film according to the present invention may be arranged in an optical path. Furthermore, the light-diffusing film according to the present invention may be used as a protection for aftermarket or a protective film for preventing damage of an organic EL display (in particular, a protective film of an organic EL display device).

### Examples

Hereinafter, the present invention is described in further detail based on examples; however, the present invention is not limited by these examples.

The raw materials used in the examples and the comparative examples are as described below, and the obtained light-diffusing films were evaluated by the following methods.

### Raw materials

Acrylic polymer having a polymerizable group: CYCLOMER P, available from Daicel-Allnex Ltd.
Acrylic polymer: 8KX-078, available from Taisei Fine Chemical Co,. Ltd.
Urethane-modified copolymer polyester resin: VYLON (trade name) UR-3200, available from Toyobo Co., Ltd.
Cellulose acetate propionate: CAP-482-20, available from Eastman; degree of acetylation = 2.5%; degree of propionyl = 46%; number average molecular weight based on calibration with polystyrene = 75000
Nanosilica-containing acrylic ultraviolet (UV) curable compound A: UVHC7800G, available from Momentive Performance Materials Japan LLC
Nanosilica-containing acrylic UV curable compound B: HP-1004, available from JGC Catalysts and Chemicals Ltd.
Silicone acrylate: EB1360, available from Daicel-Allnex Ltd.
Urethane acrylate A: UA-53H, available from Shin-Nakamura Chemical Co., Ltd.
Urethane acrylate B: AU-230, available from Tokushiki Co., Ltd.
Silicone-based hard coating material: AS-201S, available from Tokushiki Co., Ltd.
Dipentaerythritol hexaacrylate: DPHA, available from Daicel-Allnex Ltd.
Pentaerythritol tetraacrylate: PETRA, available from Daicel-Allnex Ltd.
PMMA beads: SSX-115, available from Sekisui Chemical Co., Ltd.
Crosslinked styrene beads: SX-130H, available from Soken Chemical & Engineering Co., Ltd.
Zirconia microparticle dispersion: Lioduras TYZ, available from Toyo Ink
Hollow silica gel: THRULYA, available from JGC Catalysts and Chemicals Ltd.
Photoinitiator A: Irgacure 184, available from BASF Japan Ltd.
Photo initiator B: Irgacure 907, available from BASF Japan Ltd.
Polyethylene terephthalate (PET) film: DIAFOIL, available from Mitsubishi Plastics, Inc.

### Thickness of coat layer

Randomly chosen 10 positions were measured by using an optical thickness meter, and the average value thereof was calculated.

### Haze and total light transmittance

The measurement was performed by using a haze meter (NDH-5000W, available from Nippon Denshoku Industries Co., Ltd.) in accordance with JIS K 7136.

Note that the measurement of haze was performed by arranging a surface having a recess and protrusion structure in the side of a photodetector.

The internal haze was measured by adhering a smooth transparent film and the surface irregularity of the light-diffusing layer through a transparent adhesive layer.

### 60° Gloss

The measurement was performed at the angle of 60° by using a glossmeter (IG-320, available from Horiba, Ltd.) in accordance with JIS K 7105.

### Surface metrology

The arithmetic average surface roughness (Ra) and the average interval of the recesses and protrusions (Sm) were measured by using a contact-type surface roughness tester (Surfcom 570A, available from Tokyo Seimitsu Co., Ltd.) in accordance with JIS B 0601 under the following conditions: the scanning range of 3 mm and the number of scanning of two.

### Transmitted hue (a*, b*)

The measurement was performed by using a spectrophotometer (U-3010, available from Hitachi High-Tech Science Corporation) in accordance with JIS Z 8781.

### Example 1

Twelve point five (12.5) parts by weight of acrylic polymer having a polymerizable group, 4 parts by weight of cellulose acetate propionate, 150 parts by weight of nanosilica-containing acrylic UV curable compound A, 1 part by weight of silicone acrylate, 1 part by weight of photoinitiator A, and 1 part by weight of photoinitiator B were dissolved in a mixed solvent containing 81 parts by weight of methyl ethyl ketone, 24 parts by weight of 1-butanol, and 13 parts by weight of 1-methoxy-2-propanol.

This solution was casted on a PET film by using a wire bar #20, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

### Example 2

Fifteen point zero (15.0) parts by weight of acrylic polymer having a polymerizable group,
3 parts by weight of cellulose acetate propionate,
50 parts by weight of nanosilica-containing acrylic UV curable compound A,
1 part by weight of silicone acrylate,
1 part by weight of photoinitiator A, and 1 part by weight of photoinitiator B were dissolved in a mixed solvent containing 101 parts by weight of methyl ethyl ketone and 24 parts by weight of 1-butanol.

This solution was casted on a PET film by using a wire bar #20, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

### Example 3

Twelve point five (12.5) parts by weight of acrylic polymer having a polymerizable group, 4 parts by weight of cellulose acetate propionate, 209.3 parts by weight of nanosilica-containing acrylic UV curable compound B, 1 part by weight of silicone acrylate, 1 part by weight of photoinitiator A, and 1 part by weight of photoinitiator B were dissolved in a mixed solvent containing 31 parts by weight of methyl ethyl ketone, 25 parts by weight of 1-butanol, and 12 parts by weight of 1-methoxy-2-propanol.

This solution was casted on a PET film by using a wire bar #20, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

### Example 4

Thirty-four point two (34.2) parts by weight of acrylic polymer, 20 parts by weight of urethane-modified copolymer polyester resin, 131.7 parts by weight of nanosilica-containing acrylic UV curable compound A, 1 part by weight of silicone acrylate, 1 part by weight of photoinitiator A, and 1 part by weight of photoinitiator B were dissolved in 213 parts by weight of methyl ethyl ketone.

This solution was casted on a PET film by using a wire bar #16, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

### Example 5

Thirty-four point two (34.2) parts by weight of acrylic polymer, 20 parts by weight of urethane-modified copolymer polyester resin, 131.7 parts by weight of nanosilica-containing acrylic UV curable compound A, 5 parts by weight of silicone acrylate, 1 part by weight of photoinitiator A, and 1 part by weight of photoinitiator B were dissolved in 213 parts by weight of methyl ethyl ketone.

This solution was casted on a PET film by using a wire bar #16, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

### Example 6

Forty-seven point five (47.5) parts by weight of acrylic polymer having a polymerizable group, 1.5 parts by weight of cellulose acetate propionate, 79.5 parts by weight of urethane acrylate A, 1 part by weight of photoinitiator A, and 1 part by weight of photoinitiator B were dissolved in a mixed solvent containing 175 parts by weight of methyl ethyl ketone, 28 parts by weight of 1-butanol, and 2 parts by weight of 1-methoxy-2-propanol.

This solution was casted on a PET film by using a wire bar #14, and then left in an oven at 80°C for 1 minute to vaporize the solvent. Thus, a coating layer having the thickness of approximately 6 µm was formed.

Thereafter, the coating layer was subjected to UV curing treatment by irradiating an ultraviolet ray from a high-pressure mercury lamp for approximately 5 seconds to produce a light-diffusing film.

### Comparative Example 1

Thirty-nine (39) parts by weight of urethane acrylate, 15.7 parts by weight of silicone-based hard coating material, 0.3 parts by weight of PMMA beads, and 6.1 parts by weight of crosslinked styrene beads were dissolved in 38 parts by weight of methyl ethyl ketone.

This solution was casted on a PET film by using a wire bar #14, and then left in an oven at 100°C for 1 minute to vaporize the solvent. Thus, a coating layer having the thickness of approximately 6 µm was formed.

Thereafter, the coating layer was subjected to UV curing treatment by irradiating an ultraviolet ray from a high-pressure mercury lamp for approximately 5 seconds to produce a light-diffusing film.

### Comparative Example 2

Fifty (50) parts by weight of dipentaerythritol hexaacrylate, 50 parts by weight of pentaerythritol tetraacrylate, 100 parts by weight of zirconia microparticle dispersion, 2 parts by weight of photoinitiator A, and 1 part by weight of photoinitiator B were dissolved in a mixed solvent containing 116 parts by weight of methyl ethyl ketone, 19 parts by weight of 1-butanol, and 58 parts by weight of 1-methoxy-2-propanol.

This solution was casted on a PET film by using a wire bar #14, and then left in an oven at 80°C for 1 minute to vaporize the solvent. Thus, a coating layer having the thickness of approximately 6 µm was formed.

Thereafter, the coating layer was subjected to UV curing treatment by irradiating an ultraviolet ray from a high-pressure mercury lamp for approximately 5 seconds to produce a light-diffusing film.

### Comparative Example 3

Twelve point five (12.5) parts by weight of acrylic polymer having a polymerizable group, 4 parts by weight of cellulose acetate propionate, 125 parts by weight of dipentaerythritol hexaacrylate, 1 part by weight of silicone acrylate, 75 parts by weight of hollow silica gel, 1 part by weight of photoinitiator A, and 1 part by weight of photoinitiator B were dissolved in a mixed solvent containing 56 parts by weight of methyl ethyl ketone, 11 parts by weight of 1-butanol, and 10 parts by weight of 1-methoxy-2-propanol.

This solution was casted on a PET film by using a wire bar #20, and then left in an oven at 80°C for 1 minute to vaporize the solvent. Thus, a coating layer having the thickness of approximately 9 µm was formed.

Thereafter, the coating layer was subjected to UV curing treatment by irradiating an ultraviolet ray from a high-pressure mercury lamp for approximately 5 seconds to produce a light-diffusing film.

The results obtained by evaluating characteristics of the light-diffusing film obtained in the examples and the comparative examples are shown in Table 1.

**[Table 1]**

| Items | Examples | | | | | | Comparative Examples | | |
|---|---|---|---|---|---|---|---|---|---|
| | 1 | 2 | 3 | 4 | 5 | 6 | 1 | 2 | 3 |
| Haze (%) | 79.5 | 67.8 | 87.9 | 83.2 | 91.49 | 72.2 | 83.0 | 78.3 | 80.3 |
| Internal haze (%) | 6.0 | 3.3 | 7.0 | 7.5 | 13 | 6.8 | 59.4 | 67.4 | 79.8 |
| Total light transmittance (%) | 94.0 | 94.5 | 92.0 | 97.3 | 99.2 | 96.3 | 97.4 | 94.5 | 94.3 |
| 60° Gloss (%) | 3 | 8 | 2 | 2 | 1 | 4 | 12 | 92 | 60 |
| Ra (µm) | 0.88 | 0.61 | 0.44 | 0.49 | 0.50 | 0.32 | 0.43 | 0.04 | 0.15 |
| Sm (µm) | 46.3 | 45.7 | 31.5 | 36.1 | 35.6 | 56.4 | 306.7 | 1.5 | 205.6 |
| a* | -0.22 | -0.17 | 0.07 | 0.69 | 0.45 | 0.15 | 2.20 | 2.85 | 3.32 |
| b* | 1.57 | 2.00 | 2.48 | 7.41 | 4.26 | 2.32 | 16.22 | 15.79 | 10.94 |

As is clear from the results shown in Table 1, each of the light-diffusing films of the examples achieved a high haze and excellent light-diffusing characteristics, and can suppress increase of a* and b*. On the other hand, although each of the light-diffusing films of the comparative examples have a haze that is equivalent as those of the examples, the light-diffusing film had high a* and b* and had dull appearance.

### Industrial Applicability

The light-diffusing film according to the present invention can be used as a light-diffusing film that is used in various display devices, such as liquid crystal display (LCD) devices, cold-cathode tube display devices, organic or inorganic EL displays, field emission displays (FEDs), surface-conduction electron-emitter displays (SEDs), rearprojection television displays, plasma displays, and display devices with a touchscreen.

Among these, the light-diffusing film according to the present invention is advantageous for various displays including PC monitors and televisions and can achieve good visibility and antiglare properties in a compatible manner for high-definition display devices, and thus the light-diffusing film is particularly advantageous as an antiglare film of displays and display devices with a touchscreen, such as displays for automotive navigation systems, smartphones, tablet personal computer (PC), and the like.

Furthermore, because of excellent scratch durability and capability of maintaining the optical characteristics even in a case where there is a distance from a display surface in a significantly high-definition display device (e.g. 300 ppi or higher), the light-diffusing film is particularly advantageous as a light-diffusing film for liquid crystal display devices and organic EL displays.

## Claims

1. A light-diffusing film having a haze of 50% or greater, an internal haze of 15% or less, and a total light transmittance of 90% or greater.

2. The light-diffusing film according to claim 1, wherein a chromaticity b* of transmitted light is 10 or less.

3. The light-diffusing film according to claim 1 or 2, wherein a chromaticity a* of transmitted light is 2 or less.

4. The light-diffusing film according to any one of claims 1 to 3, comprising:
a transparent base layer; and
a light-diffusing layer formed on at least one face of the transparent base layer,
wherein a 60° gloss of a surface of the said light-diffusing layer being 10% or less.

5. The light-diffusing film according to claim 4, wherein an arithmetic average surface roughness Ra of the surface of the light-diffusing layer is 0.3 µm or greater.

6. The light-diffusing film according to claim 4 or 5, wherein an average interval Sm of recesses and protrusions of the surface of the light-diffusing layer is 100 µm or less.

7. The light-diffusing film according to any one of claims 4 to 6, wherein the light-diffusing layer is a cured product of a curable composition containing at least one type of polymer component and at least one type of curable resin precursor component.

8. The light-diffusing film according to claim 7, wherein at least two components selected from the group consisting of the polymer component and the curable resin precursor component can be phase-separated by wet spinodal decomposition.

9. The light-diffusing film according to claim 7 or 8, wherein the polymer component contains at least one type selected from the group consisting of (meth)acrylic polymers that may have a polymerizable group, urethane-modified polyesters, and cellulose esters.

10. The light-diffusing film according to any one of claims 7 to 9, wherein the curable resin precursor component contains at least one type selected from the group consisting of polyfunctional (meth)acrylate, epoxy (meth)acrylate, polyester (meth)acrylate, urethane (meth)acrylate, and silicone (meth)acrylate.

11. The light-diffusing film according to any one of claims 7 to 10, wherein the curable resin precursor component contains a silica nanoparticle.

12. A method for producing the light-diffusing film according to in any one of claims 1 to 11, comprising:
phase-separating at least two components selected from the group consisting of a polymer component and a curable resin precursor component with wet spinodal decomposition by coating and drying a curable composition containing at least one type of the polymer component and at least one type of the curable resin precursor component on a support body; and
curing a phase-separated curable composition by heat or an active energy ray.

13. A display device comprising the light-diffusing film described in any one of claims 1 to 11.

14. The display device according to claim 13, wherein the display device is an organic EL display.

15. The display device according to claim 13, wherein the display device is a liquid crystal display device comprising a collimated backlight unit and no prism sheet, and the light-diffusing film is arranged on a front face of a visible side of a liquid crystal element.
